Europäisches Patentamt

**European Patent Office**

Office européen des brevets

(11) Numéro de publication: **0 165 147 B1**

## FASCICULE DE BREVET EUROPEEN

(45) Date de publication de fascicule du brevet: **05.08.92** (51) Int. Cl.5: **G06F 7/72, H04L 1/00**

(21) Numéro de dépôt: **85400989.1**

(22) Date de dépôt: **21.05.85**

(54) **Codeur-décodeur de codes de blocs, paramètrable.**

(30) Priorité: **24.05.84 FR 8408141**

(43) Date de publication de la demande:
**18.12.85 Bulletin 85/51**

(45) Mention de la délivrance du brevet:
**05.08.92 Bulletin 92/32**

(84) Etats contractants désignés:
**DE GB**

(56) Documents cités:

**IEEE JOURNAL OF SOLID-STATE CIRCUITS, vol. SC-15, no. 1, février 1980, pages 52-60, IEEE, New York, US; A.J. WEISSBERGER: "An LSI implementation of an intelligent CRC computer and programmable character comparator"**

**ICC '83 CONFERENCE RECORD OF THE IEEE INTERNATIONAL CONFERENCE ON COMMU-NICATIONS, vol. 1, Boston, Massachusetts, 19-22 juin 1983, pages A8.3.1 - A8.3.7, IEEE, New York, US; T.J. FERGUSON et al.: "Implementation of a transform decoder for reed-solomon and alternant codes"**

**G. LONGO:"ALGEBRAIC CODING THEORY AND APPLICATIONS", 1979, pages 519-527, Springer Verlag, New York, US; B. FURHT et al.: "Realization of error-free transmission using microprocessors"**

(73) Titulaire: **THOMSON-CSF**
**51, Esplanade du Général de Gaulle**
**F-92800 Puteaux(FR)**

(72) Inventeur: **Laurent, Pierre**
**THOMSON-CSF SCPI 173, bld Haussmann**
**F-75379 Paris Cedex 08(FR)**

(74) Mandataire: **Lincot, Georges et al**
**THOMSON-CSF SCPI**
**F-92045 PARIS LA DEFENSE CEDEX 67(FR)**

Rank Xerox (UK) Business Services

**Description**

L'invention se rapporte à un codeur-décodeur de codes de blocs, BCH ou RS, paramètrable. Dans un mode de réalisation préféré, ce codeur-décodeur est intégré.

La généralisation des transmissions de type numérique sur des canaux de qualité parfois médiocre, particulièrement dans le domaine du radiotéléphone et dans celui des transmissions tactiques, conduit à protéger l'information par adjonction de codes détecteurs et/ou correcteurs d'erreurs et d'effacements.

Dans les canaux classiques, la protection se fait par adjonction à l'information de caractères de contrôle, dits "caractères de parité", qui permettent de minimiser l'effet des erreurs en les détectant dans la majorité des cas. Lorsqu'une erreur est détectée, le récepteur demande la répétition du message.

Actuellement l'augmentation du trafic, dans des bandes de fréquences déjà pratiquemment saturées, et le désir d'acheminer des données rapidement et avec sécurité même en présence de brouillage conduisent à améliorer ces procédés en utilisant des procédés de codage permettant de corriger directement les erreurs, pour éviter la répétition systématique des messages et limiter ainsi le taux d'occupation du canal de transmission.

Les codes correcteurs le plus souvent utilisés sont des codes de blocs choisis dans deux grandes familles :
- les codes construits sur un alphabet binaire, généralement obtenus à partir de codes BCH, et principalement utilisés en transmission binaire lorsque les erreurs sont isolées : les symboles transmis sont des bits ;
- les codes construits sur un alphabet à M éléments (M-aire), où $M = 2^m$ , obtenus à partir de codes de type Reed-Solomon (RS) et adaptés à la correction de paquets d'erreurs : les symboles transmis sont des mots de m bits.

Suivant l'utilisation, les blocs codés ou mots de code peuvent avoir différentes longueurs, une capacité de correction plus ou moins élevée, et/ou être volontairement restreints dans leur capacité de correction pour améliorer la sécurité de transmission. Cette restriction se traduit de la manière suivante : si le code est capable de corriger t erreurs, le circuit est prévu pour n'en corriger qu'un maximum de $t_{ef}$ ($t_{ef}$ étant inférieur à t), la répétition du message étant demandée lorsque plus de $t_{ef}$ erreurs sont détectées.

Lorsque le débit utile à transmettre ne dépasse pas quelques kilobits par seconde, les opérations de codage et de décodage peuvent se faire au moyen d'un microprocesseur, bien que celui-ci n'ait pas une structure particulièrement adaptée à ce genre de traitements. En effet un microprocesseur est plutôt optimisé pour des opérations du genre arithmétique simple, et non pour des opérations arithmétiques et polynômiales sur des corps de Galois, qui sont les opérations nécessaires pour réaliser les opérations de codage et de décodage avec les codes BCH ou Reed-Solomon indiqués ci-dessus. De plus, le microprocesseur doit la plupart du temps réaliser par ailleurs d'autres opérations pour la gestion du terminal, ce qui en rend la programmation délicate.

A l'heure actuelle, la tendance est à l'augmentation du débit, rendue nécessaire par exemple pour la transmission de paroles numérisée dans un environnement perturbé. Il est donc nécessaire de mettre en oeuvre des codes performants qu'il est très difficile de traiter tant au codage qu'au décodage dans un microprocesseur.

On connaît par exemple par la demande de brevet européen EP-A-0 096109 un circuit spécialisé entièrement câblé qui permet d'effectuer des traitements. Sa structure utilisant des tables ne lui permet d'être adapté de façon souple au traitement de codes différents dans des corps de galois éventuellement différents.

La présente invention a pour objet un circuit, monolithique de préférence, standard, périphérique intelligent d'un microprocesseur, qui permet d'atteindre des débits de plusieurs dizaines de kilobits par seconde avec des taux d'erreur dans le canal de transmission élevés, ce circuit standard étant paramètrable et ainsi capable de traiter sans modification de matériel ni de logiciel tous les codes usuels des familles de codes citées précédemment (BCH et Reed-Solomon) dans leurs différentes versions, et sans aucune autre intervention du microprocesseur hôte que la définition des codes utilisés et la gestion des opérations d'entrée et sortie.

Suivant l'invention, un codeur-décodeur de codes de blocs, paramètrable, un bloc étant constitué avant codage de k symboles d'information et après codage de n symboles, n k, comportant :
- une horloge,
- un circuit d'interface adapté à la réception de blocs de données à coder ou à décoder, et à la transmission de blocs codés ou décodés ;
- un circuit de gestion
- un opérateur arithmétique pour effectuer des opérations simples sur des nombres entiers signés ;

2

- un opérateur Galois pour effectuer des additions et des multiplications sur des éléments de corps de Galois CG(M = $2^m$), où M est le nombre d'éléments du corps et m la caractéristique de ce corps, n étant au plus égal à M-1, les blocs de k symboles d'information à coder et les blocs codés de n symboles ainsi que les blocs corrigés de n symboles et les blocs décodés de k symboles appartenant au même corps ; est caractérisé en ce que :
- le circuit de gestion comporte un circuit séquenceur, une mémoire programme et un registre microinstruction associé dont la sortie est couplée à un bus d'instructions, et un circuit de décodage d'instructions et de multiplexage de tests, couplé au bus d'instructions et à un bus interne de données,
- l'opérateur arithmétique comporte une unité arithmétique et logique, une mémoire vive à double accès couplée à l'unité arithmétique et logique, l'entrée de la mémoire vive étant reliée au bus d'instructions, ou au bus interne, ou à la sortie de l'unité arithmétique et logique ou à une sortie de la mémoire elle-même, via un circuit de commutation commandée par un mot de commande de configuration issu du circuit de gestion et programmé dans la mémoire programmable,
- l'opérateur Galois comporte une mémoire vive à double accès, un multiplieur dans les corps de Galois, un additionneur dans les corps de Galois et un accumulateur, l'entrée de la mémoire étant reliée au bus d'instructions, ou au bus interne, ou à la sortie de l'accumulateur, ou à la sortie de l'additionneur ou à la sortie du multiplieur via un circuit de commutation commandé par un mot de commande de configuration issu du circuit de gestion et programmé dans la mémoire, la caractéristique m du corps Galois à utiliser étant commandée via le circuit d'interface.

L'invention sera mieux comprise et d'autres caractéristiques apparaîtront à l'aide de la description qui suit en référence aux figures annexées.

- La figure 1 est le schéma synoptique du codeur-décodeur intégré suivant l'invention.
- Les figures 2 et 3 sont des schémas détaillés d'un mode de réalisation du circuit de gestion de la figure 1.
- La figure 4 est un schéma détaillé de l'opérateur arithmétique, 300, de la figure 1.
- La figure 5 est un schéma détaillé de l'opérateur Galois, 400, de la figure 1.
- La figure 6 est un schéma détaillé du multiplieur, 470, de la figure 5.
- La figure 7 est un schéma détaillé du circuit d'interface, 500, de la figure 1.
- La figure 8 est un diagramme illustrant le format des instructions utilisables.

Le codeur-décodeur de codes de blocs intégré et paramètrable peut traiter tous les codes BCH et Reed-Solomon (RS) de la forme (n,k), n étant le nombre total de symboles par mot de code, et k le nombre de symboles d'information. Dans le mode de réalisation décrit ci-après, n peut prendre les valeurs maximales $N_{max}$ = 15, 31, 63, ou 127. Pour cela ces codes sont construits sur les corps de Galois CG(16), CG(32), CG(64) et CG(128) respectivement caractérisés par les degrés des polynômes générateurs minimaux, m = 4, 5, 6, 7.

Pour CG($2^4$ = 16) $N_{max}$ = 15 et le polynôme générateur minimal est g(X) = $X^4$ + X + 1

Pour CG($2^5$ = 32), pour lequel $N_{max}$ = 31, le polynôme générateur minimal est g(X) = $X^5$ + $X^2$ + 1

Pour CG($2^6$ = 64) où $N_{max}$ = 63, le polynôme minimal générateur est g(X) = $X^5$ + X + 1

Enfin pour CG($2^7$ = 128) où $N_{max}$ = 127, g(X) = $X^7$ + $X^3$ + 1

Il est également possible de perfectionner le mode de réalisation décrit ci-après afin de transmettre directement des octets (8 bits) en construisant ces codes sur le corps de Galois CG($2^8$ = 256) avec $N_{max}$ = 255 et un polynôme générateur g(X) = $X^5$ + $X^4$ + $X^3$ + $X^2$ + 1.

Le codage adopté est de type systématique, les symboles d'information étant inchangés et placés en tête des mots de code tandis que les symboles de redondance calculés par le procédé de codage sont mis à leur suite. Les détails concernant la mise en oeuvre d'un procédé de codage et/ou de décodage au moyen du codeur-décodeur intégré et paramètrable suivant l'invention seront décrits ci-après, après la description détaillée de ce codeur-décodeur.

Compte tenu de la complexité et de la variété des traitements que doit réaliser le circuit, le codeur-décodeur suivant l'invention a ne architecture de machine microprogrammée de façon interne, le programme écrit une fois pour toute étant stocké dans une mémoire morte non accessible à l'utilisateur. Une partie des fonctions nécessaires sont réalisées par câblage, et d'autres par logiciel. Pour donner un exemple le choix du corps de Galois utilisé n'a aucune répercussion sur le programme interne stocké dans la mémoire programme de la machine. Comme on le verra ci-après un registre tampon spécifique en stocke la valeur caractéristique et une reconfiguration automatique du codeur-décodeur est obtenue par câblage, plus particulièrement dans un générateur de constante et dans un multiplieur comme on le verra ci-après.

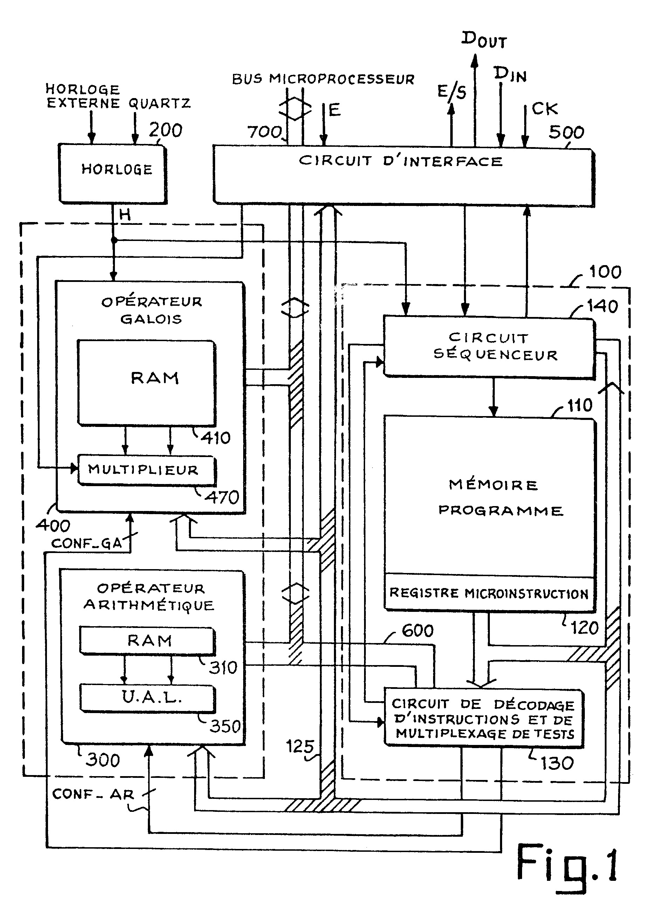

Un schéma synoptique du codeur-décodeur standard est représenté sur la figure 1, avec les principaux ensembles qui seront détaillés ci-après. Un premier ensemble 100 est un circuit de gestion et comporte un circuit séquenceur, 140, une mémoire programme ROM, 110, associée à un registre microinstruction 120 et un circuit logique câblé de décodage d'instructions et de multiplexage de tests, 130. Le circuit de décodage 130 et le circuit séquenceur 140 sont reliés au registre microinstruction 120 par un bus d'instructions 125. Cet ensemble de gestion commande deux opérateurs spécialisés : un opérateur arithmétique 300, comportant une mémoire RAM stockant et mémorisant des nombres entiers, 310, une unité arithmétique et logique simplifiée, UAL 350; et un opérateur appelé opérateur Galois 400 comportant une mémoire RAM qui stocke les symboles M-aires, 410, et un multiplieur dans le corps de Galois 470. A côté de cet ensemble, pour dialoguer avec l'extérieur, se trouve un circuit d'interface 500. L'ensemble est piloté par une horloge 200 qui peut être connectée à une horloge externe ou bien à un quartz. Les modules intervenant dans le codeur-décodeur sont reliés par un bus interne de données 600 qui peut véhiculer des informations de différentes natures, par le bus d'instructions 125 relié aux opérateurs 300 et 400 et par d'autres liaisons plus spécifiques, comme les liaisons de configuration CONF.AR et CONF.GA qui relient le circuit de décodage d'instructions 130 aux opérateurs 300 et 400. Ces liaisons spécifiques qui interconnectent les différents modules seront décrites plus en détails ci-après. L'interconnexion avec l'extérieur peut se faire soit par le bus bidirectionnel, 700, d'un microprocesseur associé avec son horloge extérieure E, soit par des fils d'entrée et de sortie de données $D_{IN}$ et $D_{OUT}$ , avec l'horloge extérieure associée CK, pour les liaisons séries.

Pour simplifier la description détaillée qui suit, les entrées d'horloge des différents circuits utilisés représentées sur les figures n'ont pas été systématiquement mentionnées.

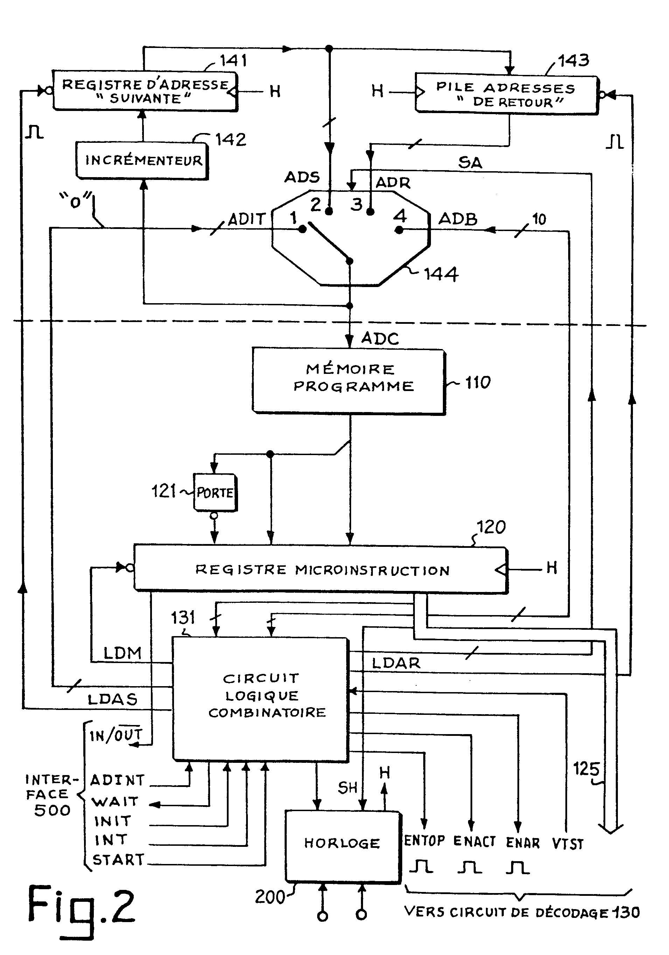

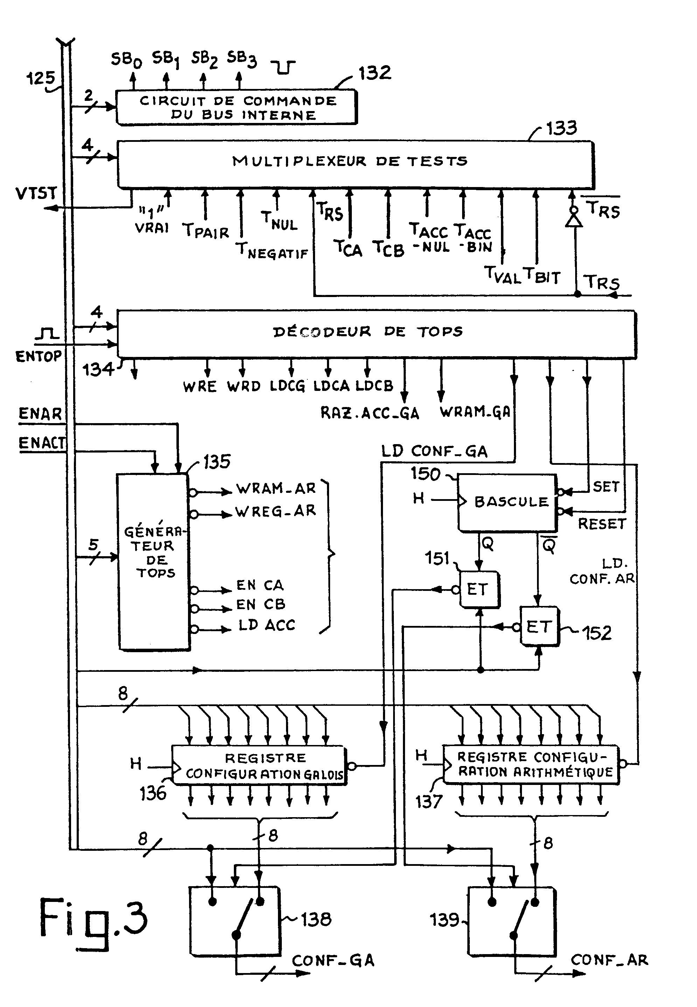

Les figures 2 et 3 montrent de manière plus détaillée un mode de réalisation de l'ensemble 100 de gestion du circuit. Sur la figure 2 on retrouve la mémoire programme 110 avec son entrée adresse et sa sortie instruction, le registre microinstruction 120, ainsi que l'horloge 200, et toutes les parties constitutives du séquenceur 140. Ce séquenceur comporte un registre d'adresse suivante 141, qui stocke l'adresse où le programme sera lors du coup d'horloge suivant. Ce registre d'adresse suivante est chargé, sur commande par une sortie LDAS d'un circuit logique 131 du circuit de décodage d'instruction 130, par la sortie d'un incrémenteur 142 à l'entrée duquel se trouve l'adresse courante ADC à un instant donné, prélevée à l'entrée d'adresse de la mémoire programme 110. Il comporte aussi une pile adresses "de retour" 143 utilisée pour les branchements des sous-programmes et pour les retours de sous-programmes, chargée par la sortie du registre d'adresse suivante 141 sur commande par une sortie LDAR du circuit logique 131. Un commutateur 144 sert à sélectionner l'adresse courante de programme transmise à l'entrée d'adresse ADC de la mémoire programme 110 parmi quatre sources qui sont :

- l'une la sortie ADIT du circuit logique 131, pour réaliser une interruption, reliée à l'entrée 1 du commutateur,
- l'adresse suivante ADS à la sortie du registre 141 reliée à l'entrée 2,
- une adresse de retour ADR disponible à la sortie de la pile 143 reliée à l'entrée 3,
- ou bien une adresse de branchement ADB disponible directement dans un champ d'adresse en sortie du registre microinstruction, 120 reliée à l'entrée 4.

Le commutateur 144 a sa position commandée par la sortie de sélection d'adresses SA du circuit logique combinatoire 131 qui tient compte de divers signaux d'entrée pour sélectionner parmi les opérations possibles soit la continuation en séquence, (entrée 2) soit le branchement conditionnel à une adresse donnée dans le programme ou l'appel d'un sous-programme donné (entrée 4), soit encore le retour d'un sous-programme (entrée 3). Une autre possibilité est encore de se dérouter en interruption (entrée 1) lorsque certains signaux d'entrée du circuit logique combinatoire ont des niveaux logiques adéquats, ceci pour tenir compte d'une interruption prioritaire en provenance de l'extérieur via l'interface 500.

Le circuit décodage d'instructions et de multiplexage de test comporte le circuit logique combinatoire 131 qui reçoit des signaux de commande de l'interface, "ADINT", "INIT", "INT", "START", un signal de validation de test VTST provenant du circuit de multiplexage de test 133 décrit ci-après, le signal d'horloge H, et une partie de l'instruction courante, et qui génère en fonction de ces signaux d'entrée et de l'instruction courante les signaux de commande de chargement indiqués ci-dessus et des signaux de validation, "ENTOP", "ENACT", "ENAR" à destination du reste du circuit de décodage d'instructions et de multiplexage de test représenté à la figure 3, ainsi qu'un signal de commande d'attente "WAIT" à destination de l'interface.

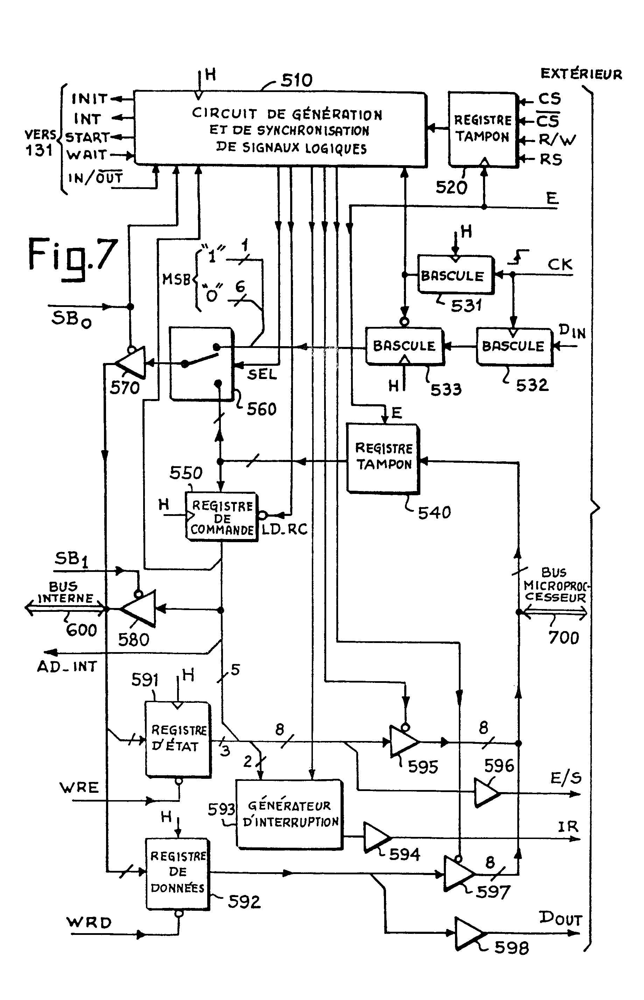

La mémoire programme 110 contient tous les programmes du circuit sous forme de mémoire morte, donc non accessible à l'extérieur et enregistrée une fois pour toutes. La sortie de cette mémoire qui correspond à l'instruction à l'adresse courante est stockée à chaque coup de l'horloge par le registre microinstruction sur commande LDM issue du registre 131; une porte 121 est prévue dans le circuit pour combiner un certain nombre de sorties de la mémoire programme avant de les enregistrer dans le registre de microinstruction, ceci pour accélérer le décodage de certaines instructions particulières telles que, par exemple, les instructions d'entrée-sortie pour lesquelles la vitesse d'exécution est critique. L'instruction disponible sur le bus instruction 125 est utilisée directement dans le séquenceur (adresses de branchement ADB), dans le circuit logique 131 du circuit de décodage et également dans le reste du circuit de décodage d'instruction et de multiplexage de test représenté sur la figure 3. Elle commande également la synchronisation SH de l'horloge 200, et l'entrée-sortie du codeur-décodeur, INT/$\overline{\text{OUT}}$ par l'intermédiaire de l'interface 500 (figure 7).

La figure 3 montre un circuit de commande 132 du bus interne 600 commandé par un champ de la microinstruction, dont les sorties permettent d'activer des "drivers" ou portes trois états pour placer sur le bus interne du circuit des données en provenance de différentes sources qui sont dans l'exemple représenté l'un des registres contenus dans l'interface 500, par les signaux $SB_0$ et $SB_1$, l'unité arithmétique et logique 350, par la sortie $SB_2$, ou une des sorties de l'opérateur Galois par la sortie $SB_3$.

Un multiplexeur de tests 133 sélectionne en fonction d'un champ de la microinstruction une valeur logique parmi plusieurs qui sont celles d'indicateurs caractéristiques de l'état interne de la machine ; le niveau sélectionné est la valeur de test logique VTST transmise au circuit combinatoire 131, qui, si le test est vrai, permet d'effectuer des branchements conditionnels et s'il est faux de les inhiber. Une entrée d'indicateur "1" (VRAI) donne la valeur de test pour les opérations non soumises à un test.

Un décodeur de tops 134 génère sur ordre d'une des entrées reliée à la sortie ENTOP du circuit logique 131, et en fonction d'une adresse définie par un champ de la microinstruction, un signal logique sur l'une de ses sorties; ce signal logique est destiné à commander l'un des sous-ensembles de la machine, par exemple l'écriture dans des registres du circuit de décodage lui-même (LD CONF-GA, LD CONF-AR), dans les registres de l'interface (WRE, WRD) ou de l'opérateur Galois (LDCG, LDCA, LDCB) la remise à zéro d'un accumulateur RAZ.ACC.CA, l'écriture dans une mémoire (WRAM.GA) de l'opérateur Galois, ou la commande d'une bascule (SET et RESET). Un générateur de tops formé d'un ensemble de portes logiques, 135, joue approximativement le même rôle que le décodeur de tops 134, sur ordre appliqué à ses entrées reliées aux sorties EN AR et EN ACT du circuit 131, mais est piloté directement par un champ de la microinstruction pour pouvoir générer simultanément différents tops à destination de différents registres, ou différentes mémoires de la machine (WRAM.AR, WREG.AR, LD-ACC., EN.CA, EN.CB). L'ensemble du décodeur de tops 134 et du générateur de tops 135 permet de réaliser en une seule opération différentes opérations d'écriture, de remise à zéro, ou de chargement.

Un registre dit de configuration Galois 136 sert à stocker, sur commande, par LD.CONF.GA (sortie du circuit 134) huit bits de la microinstruction formant un mot de configuration de l'opérateur Galois; de même un registre 137 dit "de configuration arithmétique", sert à stocker sur commande CONF.AR (sortie du circuit 134) un mot de huit bits représentatif d'une configuration de l'opérateur arithmétique. Le mot de configuration d'un opérateur commande la manière dont sont positionnés différents commutateurs à l'intérieur de cet opérateur, définit le genre d'opération qu'effectue l'opérateur par un code caractéristique, par exemple addition ou multiplication et, par exemple lorsque l'opérateur contient une mémoire vive, définit les sources d'adresses de la mémoire. Un commutateur 138 permet de choisir comme mot de configuration CONF.GA de l'opérateur Galois soit la sortie du registre 136, position "1", soit directement une partie de la microinstruction position "0", ce qui permet de piloter directement, pour une instruction particulière donnée, l'opérateur Galois à partir d'une microinstruction. Le commutateur 139 joue exactement le même rôle pour la configuration CONF.AR de l'opérateur arithmétique. Ces commutateurs 138 et 139 sont commandés par les sorties Q et $\overline{\text{Q}}$ d'une bascule 150 dont les entrées reçoivent les signaux SET et RESET du décodeur de tops 134, via les portes logiques ET 151 et 152 recevant également un bit d'instruction et utilisées pour permettre à un instant donné de choisir lequel des deux, parmi les opérateurs Galois ou arithmétique, pourra être configuré directement par la microinstruction.

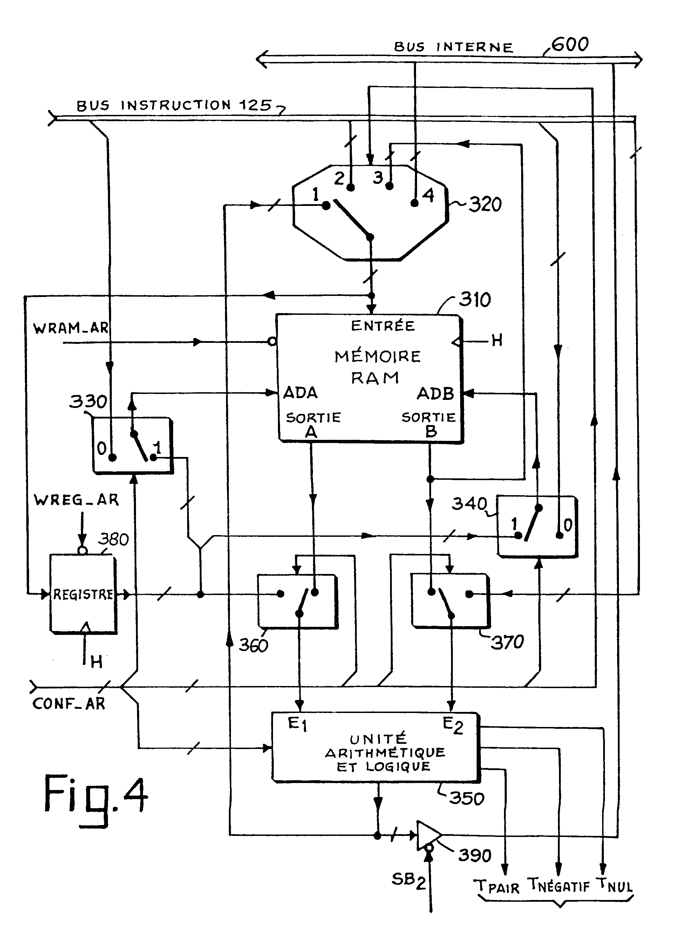

La figure 4 représente l'opérateur arithmétique dont la fonction est de réaliser des opérations arithmétiques simples sur des nombres entiers signés, en l'occurrence l'addition et la soustraction, de réaliser des opérations logiques simples sur des mots de huit bits ou octets, ces opérations étant le OU bit à bit et le ET bit à bit, pour positionner des bits à 1 ou à 0 ou en tester la valeur. Cet opérateur arithmétique se compose d'une mémoire vive à double accès 310 ayant deux entrées d'adresses ADA et ADB, une entrée de données par laquelle on vient écrire dans la mémoire sur commande d'écriture WRAM-AR une donnée sélectionnée par un commutateur 320 parmi quatre sources dont on verra le détail ci-dessous, et deux sorties A et B. Un commutateur d'adresse 330 à 2 positions permet de choisir, comme entrée d'adresse A de la mémoire, la sortie d'un registre accumulateur 380 position "1", ou bien une constante inscrite dans la microinstruction, position "0" reliée au bus d'instruction 125. De même un commutateur d'adresse 340 permet de choisir comme entrée d'adresse B de la mémoire soit la sortie du registre 380 position "1", soit une autre constante inscrite dans la microinstruction, position "0" reliée au bus d'instruction 125.

L'unité arithmétique et logique 350, chargée des opérations mentionnées précédemment, a deux entrées E1 et E2.E1 est la sortie d'un commutateur 360 qui peut choisir entre la sortie du registre 380 ou la sortie A de la RAM à double accès. L'entrée E2 est connectée à la sortie d'un commutateur 370 qui peut choisir entre une constante micro-programmée disponible sur le bus d'instruction 125 et la sortie B de la mémoire RAM arithmétique. Les commutateurs 320, 330, 340, 360 et 370, ainsi que le type d'opération à effectuer par l'unité arithmétique et logique sont commandés par le mot de configuration CONF-AR. La sortie de l'unité arithmétique et logique est reliée au bus interne 600 au moyen d'une porte trois états, 390 commandée par SB$_2$, et est reliée à une première entrée du commutateur 320. Le bus d'instruction 125, la sortie B de la mémoire RAM 310, et le bus interne 600 sont reliés respectivement aux entrées 2, 3 et 4 du commutateur 320. La sortie de ce commutateur est reliée à l'entrée de données de la mémoire 310 et également à l'entrée du registre 380, pour une éventuelle écriture dans ce registre sur commande WREG-AR, puis transmission à l'une ou l'autre des entrées d'adresses A et B de la mémoire vive 310 (via les commutateurs 330 et 340). Enfin l'unité arithmétique et logique 350 fournit également trois bits indicateurs T$_{PAIR}$, T$_{NEGATIF}$ et T$_{NUL}$ qui peuvent être testés par le multiplexeur de test 133 (figure 3), et qui indiquent si le résultat de l'opération demandée dans l'instruction courante est pair, négatif, ou nul.

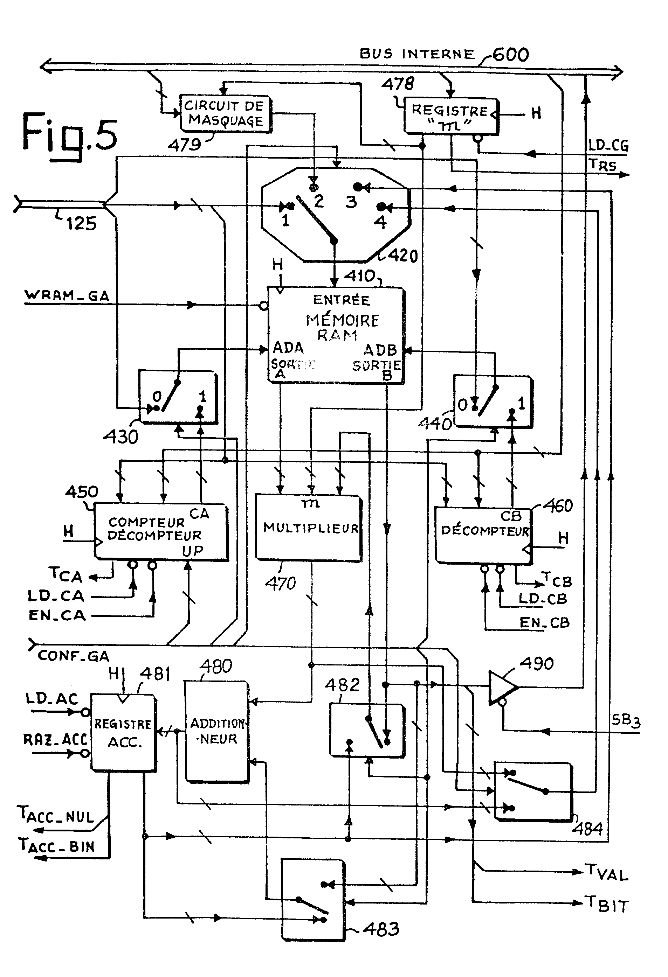

La figure 5 représente l'opérateur Galois qui est le coeur du système et qui réalise des opérations scalaires ou des opérations polynômiales sur des éléments d'un corps de Galois, qu'on appelle aussi symboles M-aires. Il comporte une mémoire vive ou RAM à double accès 410 ayant une entrée de données A, deux entrées d'adresses A et B et deux sorties A et B. L'entrée de données est reliée à la sortie d'un commutateur 420 qui permet de choisir parmi quatre sources possibles, les informations à écrire à l'adresse A dans la mémoire, sur commande d'écriture WRAM-GA. Une première entrée du commutateur est reliée au bus d'instruction 125, une seconde entrée au bus interne 600, via un circuit de masquage 479, les connexions des deux autres entrées seront décrites ci-après. L'adresse A de la mémoire est sélectionnée, par un commutateur 430, entre une valeur fournie par le bus d'instruction 125, position "0", et la sortie CA d'un compteur-décompteur 450, position "1". De même l'entrée d'adresse B est reliée à la sortie d'un commutateur 440 qui permet de choisir entre une valeur fournie par le bus d'instruction position "0" ou par la sortie CB d'un décompteur 460, position 1. Les positions des commutateurs 420, 430, 440 ainsi que le sens de comptage du compteur-décompteur 450, entrée "UP", sont commandés par le mot de configuration CONF-GA de l'opérateur Galois. Les compteurs 450 et 460 peuvent être individuellement chargés et initialisés à une valeur de neuf bits respectivement sur commande des signaux LD.CA, EN.CA et LD.CB, EN.CB issus du circuit de décodage 130 (figure 3). Les 7 bits de poids faibles sont prélevés sur le bus interne 600 et proviennent généralement de la sortie de l'unité arithmétique et logique de l'opérateur arithmétique, et les deux bits de poids fort sont prélevés sur le bus d'instructions 125. En effet les sept bits de poids faible de l'adresse de chargement des compteurs représentent très généralement le dégré d'un polynôme, degré calculé dans l'opérateur arithmétique, et les compteurs sont utilisés essentiellement dans les opérations polynominales pour l'évaluation de la valeur d'un polynôme ou d'un coefficient de degré donné du produit de deux polynômes.

L'opérateur Galois comporte en outre un opérateur appelé multiplieur dans les corps de Galois 470 dont l'une des entrées est la sortie A de la RAM et la deuxième entrée est la sortie d'un commutateur 482 qui sélectionne soit la sortie B de la mémoire RAM 410, soit la sortie d'un registre accumulateur 481. Ce multiplieur est programmable suivant le corps de Galois utilisé, corps de Galois dont l'identité, représentée par le degré m de son polynôme générateur, est prélevée sur le bus interne 600 et stockée dans un registre 478 sur commande de chargement LD.CG, et transmise à l'entrée de commande "m" du multiplieur. Ce registre 478 commande aussi le circuit de masquage 479 qui est chargé de mettre automatiquement à zéro les bits de poids fort non utilisés dans des mots de sept bits appliqués à son entrée et provenant du bus interne 600, lorsque la largeur des symboles courants est inférieure à sept bits : par exemple lors d'une utilisation d'un corps de Galois avec des symboles à quatre bits, les trois bits de poids fort doivent obligatoirement être mis à zéro pour que le multiplieur et les autres systèmes internes à l'opérateur Galois fonctionnent correctement. La sortie du multiplieur 470 est reliée à l'une des deux entrées d'un additionneur dans le corps de Galois 480, la deuxième entrée de l'additionneur étant reliée à la sortie d'un commutateur 483. La sortie de l'additionneur est reliée à l'entrée du registre accumulateur 481 et à l'une des deux entrées d'un commutateur 484. La deuxième entrée du commutateur 484 est reliée à la sortie du multiplieur 470. Le commutateur 484 fournit à la quatrième entrée du commutateur 420 le résultat d'une opération qui peut être soit une addition dans un corps de Galois (sortie de l'additionneur 480) soit une multiplication dans un corps de Galois (sortie de l'opérateur 470). La sortie du registre accumulateur 481 est reliée d'une part à une entrée du commutateur 483 dont l'autre entrée est reliée à la sortie B de la mémoire RAM 410, d'autre part à la troisième entrée du commutateur 420. Le registre accumulateur 481 peut être chargé sur commande LD.ACC et remis à zéro par la commande RZ.ACC issues du circuit de décodage 130, en particulier lors d'opérations d'évaluation de valeurs de polynômes. L'ensemble multiplieur 470, additionneur 480, accumulateur 481 peut être configuré au moyen des commutateurs 482, 483, 484, grâce au mot de configuration CONF.GA de l'opérateur Galois pour réaliser des opérations telles que la multiplication d'un polynôme par un binôme, l'évaluation de la valeur d'un polynôme, l'évaluation de la valeur d'un coefficient de degré donné du produit de deux polynômes ou encore des opérations sur des scalaires telles que la multiplication ou l'addition.

Un ensemble de portes trois états 490 a son entrée reliée à la sortie B de la mémoire vive 410, sa sortie au bus interne 600 et est commandée par la sortie $SB_3$ du circuit de commande de bus interne 132 (voir figure 3). Deux variables d'état, $T_{VAL}$ et $T_{BIT}$ sont également prélevées à la sortie B de la mémoire 410 et sont appliquées au multiplexeur de test 133 (figure 3). Le commutateur 420 qui sélectionne l'entrée A de la RAM peut choisir parmi quatre sources les informations qui seront écrites dans la mémoire : les informations peuvent être soit une constante en provenance directement d'un champ de la microinstruction, soit des données transmises sur le bus interne 600, soit la sortie de l'accumulateur 481, soit enfin la sortie du multiplexeur 470 ou la sortie de l'additionneur 480 via le commutateur 484. Ceci permet de réaliser toutes les opérations de stockage nécessaires lors des opérations de codage et de décodage.

Comme indiqué ci-dessus, l'opérateur Galois fournit au multiplexeur de test différents signaux indicateurs servant à orienter le déroulement du programme, qui sont :

- un indicateur $T_{RS}$ en sortie du registre 478 appliqué d'une part directement et d'autre part via un inverseur au multiplexeur, qui signifient respectivement que les opérations se font sur des codes Reed Solomon ou sur des codes BCH,
- un indicateur de passage par zéro $T_{CA}$ du compteur 450, et un indicateur de passage par zéro $T_{CB}$ du décompteur 460,
- $T_{ACC-NUL}$ et $T_{ACC-BIN}$ en sortie de l'accumulateur 481 qui indiquent si le contenu de l'accumulateur est nul ou bien s'il vaut 1 ou 0, c'est-à-dire s'il est purement binaire,
- les deux bits $T_{BIT}$ et $T_{VAL}$ en sortie B de la mémoire 410 qui indiquent si le mot de sortie de la RAM est un bit et si le mot de sortie de la RAM est valide. En effet dans la RAM, avec chaque symbole dont la largeur peut atteindre 7 bits, un huitième bit est ajouté qui indique si le symbole est valide ou non ; ce huitième bit est utilisé pour la localisation des effacements.

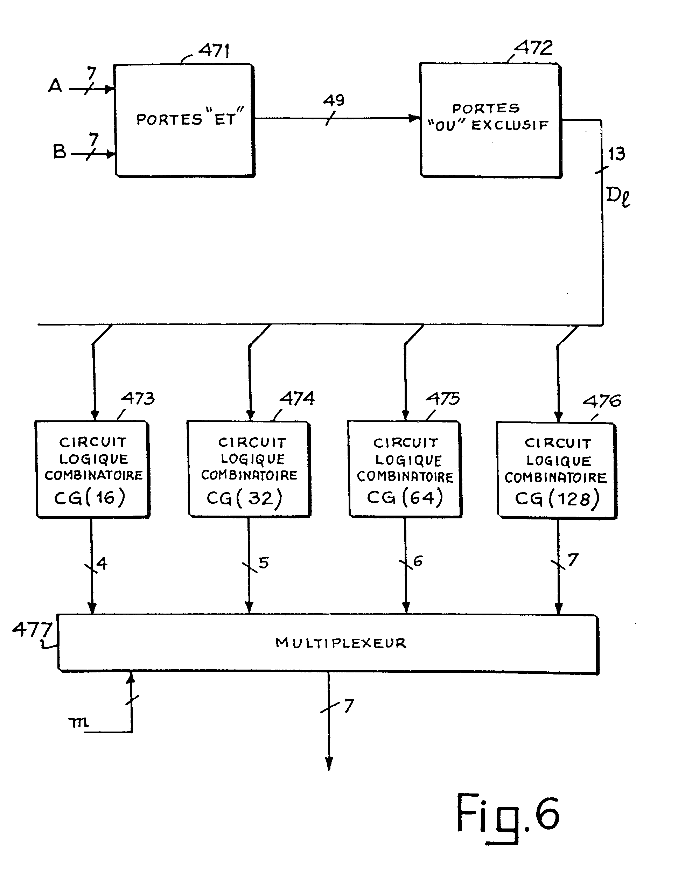

La figure 6 représente un exemple de réalisation du multiplieur 470, programmable dans les différents corps de Galois utilisables dans ce mode de réalisation. Pour l'exemple les différents de corps de Galois utilisés ont respectivement 16, 32, 64 et 128 éléments, et peuvent être générés par des polynômes de degré m au plus égal à 7. Le multiplieur comporte dans ce cas un ensemble de $m^2 = 7^2 = 49$ portes ET, 471, qui sert à faire tous les produits bit à bit des deux opérandes A et B. Soit,

si $A = a_0 + a_1 X + a_2 X^2 + ... a_i X^i + ... a_6 X^6$ et
si $B = b_0 + b_1 X ... + b_j X^j + ...b_6 X^6$,

tous les produits $a_i b_j \forall i$ et $j$ compris entre 0 et 6. Les sorties de ces portes sont aiguillées vers un ensemble de portes OU exclusif, 472, qui sert à calculer les 2 m-1 termes de différents degrés du produit ; ces termes $D_q$, avec $q = i + j$ sont au maximum au nombre de 13, q = 0 à 12, pour CG ($128 = 2^{m=7}$) et sont toujours les mêmes :

- $D_0 = a_0 + b_0$
- $D_1 = a_0 b_1 + a_1 b_0$
- $D_2 = a_0 b_2 + a_1 b_1 + a_2 b_0$
- . . . . . . . . . . . . .
- $D_{11} = a_5 b_6 + a_6 b_5$
- $D_{12} = a_6 b_6$ .

Dans un mode de réalisation utilisant des portes OU exclusif à 2 entrées, cet ensemble 472 comporte 36 portes. Les 13 sorties de cet ensemble sont reliées aux entrées de circuits logiques combinatoires 473, 474, 473 et 476 respectivement associés aux corps de Galois CG(16) CG(32), CG(64) et CG(128) qui les combinent pour que leurs sorties soient effectivement la représentation dans le corps de Galois concerné du produit des arguments A et B en tenant des propriétés des éléments de ces ensembles. Pour CG(M = $16 = 2^{m=4}$), les 4 termes de degrés 0 à 3 sont fonctions des 2m-1 termes Dq :

$P_0 = D_0 + D_4$ ; $P_1 = D_1 + D_4 + D_5$ ; $P_2 = D_2 + D_5 + D_6$ ; $P_3 = D_3 + D_6$ .

Pour CG(32) les m = 5 termes sont :

$P_0 = D_0 + D_5 + D_8$ ; $P_1 + D_1 + D_6$ ; $P_2 = D_2 + D_5 + D_7 + D_8$ ; $P_3 = D_3 + D_6 + D_8$ ; $P_4 = D_4 + D_7$ .

Pour CG(64), les m = 6 termes sont :

$P_0 = D_0 + D_6$ ; $P_1 = D_1 + D_6 + D_7$ ; $P_2 = D_2 + D_7 + D_8$ ; $P_3 = D_3 D_8 + D_9$ ; $P_4 = D_4 + D_9 + D_{10}$ ; $P_5 = D_5 + D_{10}$

et pour CG(128) les m = 7 termes sont :

$P_0 = D_0 + D_7 + D_{11}$ ; $P_1 = D_1 + D_8 + D_{12}$ ; $P_2 = D_2 + D_9$ ; $P_3 = D_3 + D_7 + D_{10} + D_{11}$ ; $P_4 = D_4 + D_8 + D_{11} + D_{12}$ ; $P_5 = D_5 + D_9 + D_{12}$ ; $P_6 = D_6 + D_{10}$ .

Le choix des sorties utilisées se fait par le multiplexeur 477 en fonction de l'identité m du corps de Galois fournie par la sortie du registre 478.

La figure 7 représente un exemple de réalisation du circuit d'interface qui assure la liaison entre l'extérieur, représenté par un microprocesseur et/ou un système d'entrée-sortie de données en série et le reste du circuit.

Un ensemble de bascules et de portes forme un circuit 510 de génération et de synchronisation de signaux logiques. Il génère et synchronise les différents signaux logiques nécessaires au fonctionnement de l'interface et au dialogue avec le circuit de gestion 100 (figures 1, 2 et 3), et nécessaires au séquencement, en particulier les signaux destinés au circuit de décodage d'instructions 130, INIT, INT, START. Il reçoit le signal de commande d'attente WAIT issu de ce même circuit ainsi que le signal de commande d'entrée-sortie $INT/\overline{OUT}$. L'une des entrées de ce circuit logique 510 est reliée à la sortie d'un registre tampon 520 qui vient stocker, sur les fronts de l'horloge extérieure E du microprocesseur les signaux classiques d'interfaçage tels que les signaux de sélection de chips, CS et $\overline{CS}$, de lecture-écriture sur le registre interne $R/\overline{W}$ et RS. Un ensemble de bascules 531, 532, 533 pilotées par le signal d'horloge externe série CK, et par le signal d'horloge H du codeur-décodeur, est chargé de remettre en forme les données présentes sur l'entrée série $D_{IN}$ du circuit (voir figure 1). De même que les données d'entrée série sont synchronisées, les données en accès parallèle par le bus bi-directionnel 700 du microprocesseur sont enregistrées dans un registre tampon d'entrée 540 sur commande des fronts montants de l'horloge E du microprocesseur. Lorsque ces données représentent une commande en provenance du microprocesseur, elles sont aussitôt stockées dans un registre, 550, appelé registre de commande, dont le chargement est commandé par une sortie LD.RC du circuit logique 510.

Les données d'entrée peuvent être transmises sur le bus interne 600 via un commutateur 560 et une porte trois états 570 commandée par le signal $SB_0$ issu du circuit de commande 132 du bus interne et également appliqué au circuit logique 510. Ce commutateur 560 a ses entrées reliées à la sortie du registre tampon d'entrée 540 et à la sortie de la bascule resynchronisée 533. L'une ou l'autre de ces entrées transmet des données d'entrée au bus interne 600, sur commande du commutateur par un signal de sélection SEL fourni par le circuit logique 510. Pour les données issues de la bascule 533, un seul bit est fourni par la bascule et il est nécessaire de fournir six bits complémentaires à zéro et un bit de poids fort à 1 pour signifier que le bit est valide. Ceci est réalisé par câblage sur des entrées MSB. La sortie du registre de commande 550 est reliée à une entrée du circuit logique 510 car le fonctionnement de ce circuit logique dépend du dernier mot de commande reçu ; en effet le fonctionnement des entréessorties diffère suivant le mot de commande : les signaux générés par le circuit logique 510 sont différents si l'entrée se fait sous forme série ou si elle se fait sous forme parallèle. La sortie du registre 550 peut également être placée sur le bus 600 par l'intermédiaire d'une porte trois états 580 commandée par le signal $SB_1$ issu du circuit de commande 132 du bus interne, et certains bits AD.INT peuvent être transmis directement au circuit logique 131 du circuit de décodage d'instructions 130.

Dans l'autre sens, deux types de données peuvent être fournis vers l'extérieur ; ces données sont présentes sur le bus interne 600 à certains moments du fonctionnement du codeur-décodeur. Lorsqu'elles représentent l'état du circuit, elles sont enregistrées dans un registre d'état 591, et lorsqu'elles représentent des données à fournir a l'extérieur, telles que par exemple des symboles après codage ou des symboles après décodage, elles sont enregistrées dans le registre de données 592. Les entrées de données de ces registres sont donc reliées au bus interne et leurs entrées de commande reçoivent les signaux WRE et WRD du décodeur de tops 134 du circuit de décodage d'instructions 130.

8

Le microprocesseur peut lire directement le contenu du registre d'état 591 et d'une partie du registre de commande formant un mot d'état, par l'intermédiaire d'une porte trois états 595 dont l'entrée de données est reliée à la sortie du registre 591 et à la sortie du registre 550 et dont l'entrée de commande reçoit un signal de commande du circuit logique 510. Ceci peut se faire sans aucune influence sur le fonctionnement du codeur-décodeur. La lecture du mot d'état, transmis sur le bus du microprocesseur est transparente. Un bit du mot d'état à la sortie du registre 591 peut être transmis sur une connexion de sortie E/S via une porte d'amplification 596 lorsque les entrées-sorties se font sous forme série ; ceci permet à un modem qui dialogue avec le codeur-décodeur de savoir que l'opération demandée, par exemple un codage, est en cours d'exécution ou vient de se terminer.

Le schéma de la figure 7 montre que le mot d'état se compose d'un certain nombre de bits qui sont positionnés par le circuit lui-même via le bus interne 600 et d'une partie des bits du mot de commande à la sortie du registre de commande 550 qui sont ré-envoyés, tels quels, vers l'extérieur. Ceci permet au microprocesseur d'éviter d'avoir à mémoriser les commandes qu'il a transmises vers le circuit d'interface car elles sont enregistrées dans le registre 550.

La sortie des données vers le microprocesseur se fait via une porte trois états 597, commandée par un signal de commande de sortie issu du circuit logique 510, qui délivre sur le bus externe 700 du microprocesseur le contenu du registre 592 où l'information a été stockée au préalable. Le bit de poids faible de cette information est disponible directement sur une connexion de sortie $D_{OUT}$ du circuit d'interface via un amplificateur 598 pour les sorties série.

Enfin le microprocesseur peut fonctionner en mode interruption, pour éviter d'avoir à scruter en permanence l'état du circuit pour savoir s'il peut avoir accès aux données résultant d'un codage ou d'un décodage demandé ; pour cela un système générateur d'interruption, masquable, constitué d'un générateur d'interruption 593, dont la sortie est reliée à une porte collecteur-ouvert 594 fournissant le signal d'interruption IR est prévu. Le générateur d'interruption a une entrée reliée à la sortie du registre d'état 591 et une entrée de commande reliée à une sortie du circuit logique 510, et est commandé par le changement d'état de certains bits du mot d'état stocké dans le registre 591.

Le fonctionnement du circuit sera mieux compris à l'aide d'un exemple précis. On propose comme exemple l'évaluation de la valeur d'un polynôme de degré n-1 suivant la méthode de HORNER, évaluation qui est par exemple mise en oeuvre dans le calcul des syndromes $S_P$ lors d'un décodage. Une telle évaluation est réalisée en n coups d'horloge en suivant la formule suivante :

$a_0 + a_1 X + a_2 X^2 + ... + a_{n-1} X^{n-1}$
$- a_0 + X (a_1 + X (a_2 + ... + X (a_{n-2} + a_{n-1} X) ...))$
$- 1^{er}$ pas : $a_{n-1}$
$- 2^e$ : $a_{n-1} X + a_{n-2}$
$- 3^e$ : $(a_{n-1} X + a_{n-2}) X + a_{n-3}$
$- 4^e$ : $(a_{n-1} X^2 + a_{n-2} X + a_{n-3}) X + a_{n-4}$
$- ...$
$-n-1^e$ pas : $(a_{n-1} X^{n-3} + a_{n-2} X^{n-4} + ... + a_2) X + a_1$
$-n^e$ pas : $(a_{n-1} X^{n-2} + a_{n-2} X^{n-3} + ... a_2 X + a_1) X + a_0$ .

Cette opération met en effet en jeu à la fois l'opérateur arithmétique et l'opérateur Galois, ce qui permettra de mettre en évidence les relations qui existent entre les deux. On suppose par exemple que le degré n-1 du polynôme se trouve stocké dans la mémoire RAM 310 de l'opérateur arithmétique à l'adresse 5, que d'autre part les n coefficients de ce polynôme $a_0$, $a_1$, ... $a_{n-1}$, ont été stockés dans la mémoire RAM 410 de l'opérateur Galois, dans la troisième page, c'est-à-dire celle dont les 2 bits de poids fort sont tous les deux à 1, et depuis l'adresse 0 jusqu'à l'adresse n-1 dans cette page. Le déroulement des opérations peut être décrit ainsi :

Tout d'abord le décompteur 460 est chargé avec la valeur de n-1, degré du polynôme. Pour cela cette valeur de n-1 peut être mise sur le bus 600 par le signal d'activation $SB_2$ de la porte trois états 390 située en sortie de l'unité arithmétique 350 ; les deux entrées E1 et E2 de cette UAL sont reliées, par l'intermédiaire des commutateurs 360 et 370, aux sorties A et B de la mémoire arithmétique 310. Les adresses A et B sont sélectionnées toutes deux par les commutateurs 330 et 340 à la même valeur 5 par la constante microprogrammée, adresse où se trouve justement le degré du polynôme. L'opération sélectionnée dans l'unité arithmétique 350 par le mot de configuration CONF.AR de l'opérateur arithmétique est l'opération OU ; ainsi sa sortie transfère sur le bus interne 600 un nombre qui est la représentation du OU bit à bit du contenu de la mémoire 310 à l'adresse 5 avec lui-même, c'est-à-dire le nombre n-1 lui-même. Le décompteur 460 de l'opérateur Galois est alors chargé avec un mot de neuf bits, dont les sept bits de poids faible sont le contenu du bus interne, c'est-à-dire le degré n-1 du polynôme, qui est également l'adresse du coefficient de plus haut degré $a_{n-1}$ , du polynôme, et les deux bits de poids fort représentent la valeur 3 qui est le numéro de la page où se trouvent les coefficients $a_i$ du polynôme à évaluer, valeur 3 qui est fournie directement en sortie par le bus d'instruction 125.

L'opération suivante consiste à remettre à zéro l'accumulateur de l'opérateur Galois, 481, qui à la fin de l'opération contiendra la valeur du polynôme. Une autre phase préparatoire de l'opération consiste à charger le registre 478 de l'opérateur Galois et le registre de configuration Galois 136 du circuit de décodage d'instruction 130 (figure 2) de telle sorte que, dans l'opérateur Galois,
- le commutateur 482 ait son entrée reliée en sortie de l'accumulateur,
- le commutateur 483 ait son entrée reliée à la sortie B de la RAM 410,
- l'entrée adresse A de la mémoire RAM à double accès 410 (reliée à la sortie du commutateur 430) soit reliée au bus d'instruction 125, pour recevoir une constante microprogrammée qui est l'adresse de la valeur de l'inconnue X pour laquelle le polynôme doit être évalué,
- et l'entrée d'adresse B de la RAM 410 soit reliée via le commutateur 440 à la sortie du décompteur 460.

A partir de ce moment l'opération d'évaluation de la valeur du polynôme est réalisée en n opérations élémentaires qui comportent chacune
- le calcul du produit de l'inconnue X par l'ancienne valeur de l'accumulateur, 0 pour la première opération, $a_{n-1}$ pour la seconde, ($a_{n-1}$ X + $a_{n-2}$) pour la troisième, etc...
- le calcul de la somme du produit calculé et du coefficient présent à la sortie B de la mémoire RAM ($a_{n-1}$ , $a_{n-2}$ ... $a_0$ pour les n opérations successives)
- un chargement de l'accumulateur par la sortie de l'additionneur,
- une décrémentation du décompteur 460.

Le processus s'arrête lorsque les sept bits de poids faibles du compteur 460 sont à zéro, ce qui est signalé au séquenceur par une activation du test de l'état zéro $T_{CB}$ du décompteur 460 ; à ce moment, l'opération d'évaluation du polynôme est terminée et sa valeur se trouve dans l'accumulateur. Cette valeur peut être stockée dans la mémoire 410 en positionnant le commutateur 420 en position 3 sur la sortie de l'accumulateur 481, et en l'écrivant à une adresse disponible à la sortie du commutateur 430 et qui est définie soit par une constante microprogrammée soit encore par le contenu courant du compteur-décompteur 450. C'est cette dernière solution qui est adoptée lorsque l'on évalue les syndrômes $S_i$ que l'on range dans des adresses successives de la RAM 410, pour un traitement ultérieur, lorsqu'un décodage a été demandé par l'extérieur.

Les fonctions précises des différents modules constitutifs du circuit codeur-décodeur décrit ci-dessus pourront maintenant être mieux comprises.

Le séquenceur 140 avec la mémoire morte 110 qui lui est associée se charge de la gestion des opérations d'entrée-sortie du codage et du décodage. Pour cela le séquenceur dispose d'un jeu réduit d'instructions parmi lesquelles on trouve, outre l'instruction classique qui commande l'exécution d'opérations en séquence, d'autres instructions commandant :
- le branchement, l'appel de sous-programme (à un seul niveau), le retour de sous-programme, ces branchements pouvant être soit conditionnels soit inconditionnels ;
- des instructions commandant l'exécution conditionnelle d'opérations ;
- des instructions commandant l'exécution répétitive d'opérations, une seule instruction permettant par exemple d'effectuer l'évaluation d'un polynôme, comme expliqué ci-dessus ;
- l'attente d'entrée-sortie.

Le séquenceur est également construit pour répondre à des interruptions directement câblées, les trois premières INIT, INT, et START correspondent à l'arrivée d'une commande externe et sont transmises via l'interface, la quatrième VTST correspond à la fonction de test du circuit et est issue du multiplexeur de tests 133 du circuit 130 de décodage d'instructions et de multiplexage de tests.

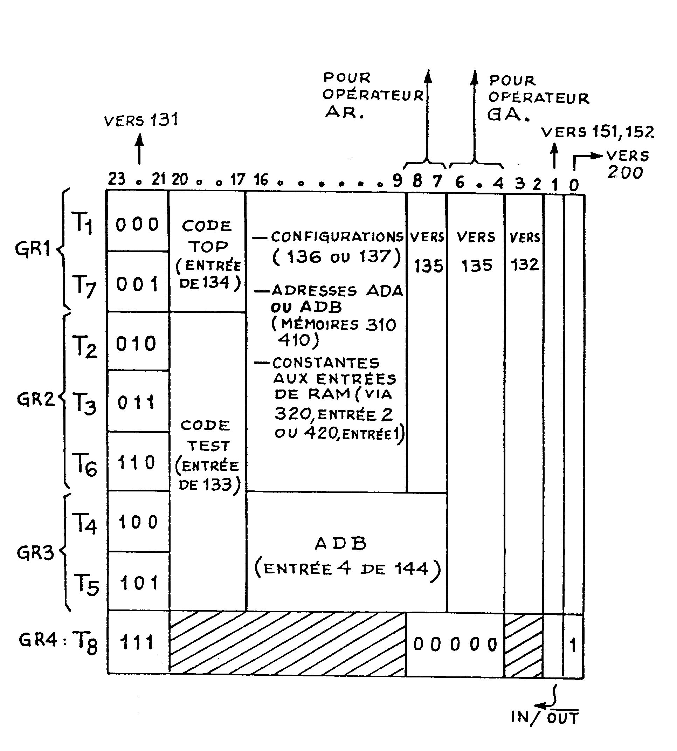

Le format des instructions est optimisé pour l'application, et la signification des différents camps d'une instruction donnée dépend de son type. Un même champ peut être à un instant donné une adresse mémoire, ou comporter la valeur d'une constante, ou être une partie d'une adresse de branchement etc... La figure 8 est un exemple du format des instructions qui peuvent être issues de la mémoire programme. Les instructions sont codées sur trois octets et sont regroupées en huit types, dont les codes sont donnés par les trois derniers bits de l'instruction, euxmême regroupés en quatre groupes. Les trois bits caractérisant un type d'instructions sont utilisés dans le circuit logique combinatoire 131 pour générer les signaux de commande.

Les bits 17 à 20 d'une microinstruction sont le code de commande soit du décodeur de tops 134, soit du multiplexeur de tests 133, suivant le groupe d'instructions correspondant, appliqué à l'entrée de 134 pour le groupe 1 et à l'entrée de 133 pour le groupe 2. Les bits 9 à 16 d'une microinstruction sont des données caractérisant soit des configurations d'opérateurs, configuration de l'opérateur Galois stockée dans le registre 136 ou configuration de l'opérateur arithmétique stockée dans le registre 137, soit des adresses appliquées aux entrées d'adresses ADA ou ADB des mémoires 310 ou 410, soit enfin des constantes appliquées aux entrées des mémoires à double accès 310 ou 410 via les commutateurs respectivement 320 (entrée 2) ou 420 (entrée 1), la signification de ces bits étant fonction du type et du groupe de l'instruction (groupe 1 et groupe 2). Pour ces mêmes groupes 1 et 2 les bits 7 et 8 sont appliqués à l'entrée de commande du générateur de tops 135. Pour les instructions du groupe 3 comportant les types 4 et 5, les bits 7 à 16 représentent des adresses de branchement qui sont appliquées à l'entrée 4 du commutateur 144 du séquenceur, et désigne des adresses de branchement dans la mémoire programme 110.

Pour les trois groupes 1, 2 et 3, les bits 4 à 6 sont destinés à la commande de l'opérateur Galois et appliqués au décodeur de tops 135. Pour ces trois groupes également, les bits 2 et 3 sont un code de commande du circuit de commande du bus interne 132. Enfin le bit 1 est appliqué aux portes ET 151 et 152 et le bit 0 est utilisé pour la commande de la vitesse de l'horloge SH.

Les instructions du groupe 4, correspondant au type 8 et caractérisées par le code de type 111, sont utilisées pour le transfert de données, le bit de rang 0 mis à 1 indique une horloge rapide et le bit de rang 1 indique le sens du transfert, IN-$\overline{\text{OUT}}$. Les bits 4 à 8 sont mis à zéro dans ce cas.

L'opérateur arithmétique décrit ci-dessus comporte les éléments strictement indispensables pour effectuer les traitements d'un nombre entier signé, par exemple des indices ou des octets représentant des pointeurs, des indices ou des variables diverses, et contient comme indiqué ci-dessus la mémoire vive à double accès de faible capacité et une unité arithmétique logique simplifiée capable seulement des opérations suivantes sur des mots de huit bits : addition signée, soustraction signée, OU bit à bit pour positionner des bits à 1, ET bit à bit pour positionner des bits à 0 et tester des bits. Il contient également le registre accumulateur 380 pouvant servir entre autres à l'adressage de la mémoire, et des commutateurs autorisant la configuration des chemins de données et d'adresses en fonction des besoins.

L'opérateur Galois a une structure comparable à celle de l'opérateur arithmétique mais, comme il résulte de la description ci-dessus un effort particulier a été fait pour optimiser son architecture afin d'accélérer les traitements répétitifs. Pour cela la mémoire vive à double accès 410 est découpée en pages, elles-mêmes découpées en sous-pages. La sous-page de rang global la plus faible est utilisée pour mettre en mémoire les scalaires, les autres pour la mise en mémoire des coefficients de polynômes. L'opérateur Galois comporte en outre comme indiqué ci-dessus les deux compteurs d'adresses, l'un fonctionnant en compteur ou décompteur et l'autre en décompteur seulement, ces compteurs pouvant être chargés par une valeur provenant de l'opérateur arithmétique. L'opérateur comporte en outre un additionneur dans le corps de Galois et un multiplieur dans les corps de Galois programmable comme indiqué ci-dessus par câblage, ainsi qu'un registre accumulateur et des commutateurs autorisant la configuration des chemins de données et d'adresses suivant les besoins.

Enfin l'interface est conçue pour que le fonctionnement des parties programmées du codeur-décodeur soit aussi indépendant que possible de l'environnement extérieur. Ainsi, comme expliqué ci-dessus, l'interface se charge de la mise en forme et de la synchronisation de différents signaux, des aiguillages et masquages des diverses informations entrantes et sortantes, du stockage de paramètres de fonctionnement, et de la mise en mémoire du mot de commande et du mot d'état, ce dernier pouvant être lu par l'extérieur sans aucun effet sur le fonctionnement du circuit.

Ainsi le codeur-décodeur de codes de blocs décrit est paramètrable et peut être considéré comme un composant standard d'usage général dans les transmissions numériques du fait de sa très grande flexibilité. Dans sa forme de réalisation intégrée préférée, il se présente sous forme d'un composant unique assurant la transparence entre l'utilisateur origine ou destinataire de l'information utile, et le canal de transmission où une certaine protection doit être mise en oeuvre. Sa complexité, sa surface et sa consommation estimées sont de l'ordre de celles qu'atteignent dès aujourd'hui les circuits VLS1.

Les algorithmes de codage et de décodage par des codes de blocs préconisés pour une mise en oeuvre dans ce circuit codeur-décodeur standard sont ceux, parmi les algorithmes connus en soi, qui permettent de trouver un compromis favorable entre la complexité et la vitesse d'exécution. En particulier, il est préférable dans certains cas d'utiliser des procédés qui peuvent paraître peu élaborés du point de vue théorique mais qui peuvent être facilement implémentés dans le circuit. Ainsi les algorithmes préconisés sont ceux qui ne mettent en oeuvre que des opérations d'addition et de multiplication dans les corps de Galois. Ceux qui mettent en oeuvre des évaluations de logarithmes, des exponentiations, ou des calculs d'inverses, ne peuvent pas être mis en oeuvre par le codeur-décodeur intégré suivant l'invention. Enfin à de petits détails près les mêmes algorithmes sont utilisés pour les codes BCH où les symboles sont des bits, et pour les codes RS, où les symboles comportent plusieurs bits.

La description de ces algorithmes peut être trouvée par exemple dans les documents suivants :
- Algebraic Coding Theory, E.R. BERLEKAMP, McGRAW-HILL, 1968
- Error Correcting Codes, W.W.PERTERSON et E.J.WELDON, MIT Press 1972
- Error Correction Coding for Digital Communications, G.C.CLARK et J.B.CAIN, Plenum Press NY et London, 1982.

La description succincte ci-après rappelle les principales étapes d'un codage ou d'un décodage selon un code de blocs, qui peuvent être mises en oeuvre dans le codeur-décodeur décrit ci-dessus.

Un mot de code peut être représenté sous la forme d'un polynôme $C(X) = c_{n-1} X^{n-1} + c_{n-2} X^{n-2} + etc... + c_1 X + c_0$. Suivant la définition des codes BCH et RS, ce polynôme doit être multiple d'un polynôme G-(X) dit générateur de code, indiqué ci-dessus, dont les racines sont 2t puissances successives d'un élément du corps de Galois concerné.

Dans l'application, cet élément de base est choisi "primitif", c'est-à-dire que chacun des éléments du corps de Galois est égal à une puissance entière de cet élément à l'exception de 0, et on adopte la convention suivante où a désigne l'élément primitif indiqué ci-dessus, racine du polynôme $G(X) : G(a^P) = 0$ pour p = 1, 2, ... , 2t (pour des codes de distance 2t + 1).

Et $G(a^P) = 0$ pour p = 0, 1, 2 ... , 2t (pour des codes de distance 2t + 2).

Le codage est réalisé de la manière suivante :

Dans une première phase, les k symboles d'informations d'un bloc sont recopiés en tête du mot de code.

Dans une deuxième phase, on réalise le calcul des symboles de redondance. Le calcul du premier symbole de redondance est réalisé par sommation pondérée des k symboles d'informations. Si n, nombre de symboles par mot de code, est inférieur à $N_{max}$, les $N_{max} - n$ symboles de poids forts, correspondant aux degrés élevés dans la représentation polynomiale, sont initialisés à 0. Puis chacun des symboles de redondance suivant est calculé par sommation pondérée des symboles existants. Les coefficients de pondération sont calculés dans une phase d'initialisation, et sont les coefficients d'un polynôme H(X) défini de la manière suivante et ne dépendant que du corps de Galois choisi, de la nature du code, et de la distance choisie pour ce code :

$$H(X) = \frac{X^{M-1} - 1}{G(X)} = h_0 + h_1 X + h_2 X^2 + ... + h_{M-1-d} X^{M-1-d},$$

d est le degré de G(X) polynôme générateur, où M est caractéristique du corps de Galois, et où G(X) est le polynôme générateur du code tel que défini précédemment.

Le décodage s'effectue quant à lui en cinq étapes dont certaines peuvent être abrégées voire supprimées suivant les cas :

Dans une première phase, les effacements sont repérés, et une première version d'un polynôme localisateur d'errata est calculé, L(Z), ce polynôme ayant pour racines les inverses des positions desdits errata. Un erratum est une erreur franche (dont on ne connaît pas la position), ou un effacement, symbole à valeur douteuse ou non définie dont on connaît la position. La position $X_i$ , i = 1 à e, d'un erratum affectant le coefficient de dégré p du mot reçu, dans la représentation polynomiale, est égale à la puissance $p^{ième}$ de a. Le polynôme localisateur peut donc être écrit sous forme : $L(Z) = (1 - X_1 Z) (1 - X_2 Z) ... (1 - X_e Z)$, e étant le nombre d'effacements.

Dans une seconde phase, le codeur-décodeur calcule des syndrômes $S_P$, qui sont les valeurs prises par le polynôme C(X) après réception, et qui peuvent différer de ses valeurs à l'émission. Si on note ce polynôme reçu C'(X), il s'exprime en fonction de C(X) de la manière suivante :

$C'(X) = C(X) + E(X)$

Les syndromes $S_P$ ont les valeurs suivantes : $S_P = C'(a^P)$, avec p = 1, 2, ... 2t.

Le polynôme E(X) est appelé polynôme d'errata. Ses seuls coefficients non nuls ne peuvent être qu'à des positions correspondant aux errata (erreurs ou effacements) et ont des valeurs égales à celles des errata en question.

Dans une troisième phase, le polynôme L(Z) est prolongé progressivement par l'algorithme de Berlekamp pour augmenter son degré en tenant compte des syndrômes, d'une manière classique. L(Z) se voit alors affecter des racines supplémentaires qui sont les inverses des positions d'erreurs, qui sont ainsi détectées, tant que la capacité du code n'est pas dépassée.

Dans une quatrième phase, le codeur-décodeur calcule la transformée de Fourier du polynôme d'errata E(Z), cette transformée étant calculée à partir des syndrômes $S_P$ et du polynôme localisateur d'errata L(Z).

Dans une cinquième phase, le polynôme E(Z) est calculé par transformation de Fourier inverse puis correction des erreurs et reconstitution des effacements pour obtenir le polynôme de départ C(X).

Dans chaque phase des vérifications sont faites pour éviter les faux décodages. Par exemple dans le cas des codes BCH, lors du calcul du polynôme E(Z), le codeur-décodeur vérifie que les valeurs des errata sont bien égales à 0 ou à 1. De même si la capacité de correction effective demandée est dépassée, même si la capacité maximale ne l'est pas, l'algorithme de décodage se termine par un diagnostic de non décodage, qui peut commander dans un modulateur-démodulateur associé une demande de répétition. Enfin lorsque la distance du code est égale à 2t + 2, le décodeur vérifie que le syndrôme $S_0$, qui est la valeur de C'(X) pour X = 1 a la valeur convenable. Si ce n'est pas le cas, l'algorithme de décodage se termine sur un diagnostic de non décodage.

Ces procédés de codage et décodage sont connus en soi et le codeur-décodeur suivant l'invention permet de les mettre en oeuvre dans de bonnes conditions. La programmation de la mémoire 110 pour les opérations d'initialisation, et de codage et de décodage suivant ces algorithmes connus en soi, est à la portée de l'homme de l'art et n'a donc pas été décrite dans tous ses détails ici.

Les codes utilisés peuvent corriger un nombre t d'erreurs compris entre 1 et un maximum qui dépend du corps de Galois et de la nature du code utilisé (BCH ou RS) sans toutefois pouvoir dépasser actuellement 15 pour des raisons technologiques. En effet, pour des codes RS comportant au maximum 127 symboles, la taille de la mémoire 410 est de l'ordre de 500 mots de 7 ou 8 bits si l'on corrige au plus 15 erreurs, compte tenu des nombres et degrés des polynômes qui doivent être simultanément mémorisés lors d'un décodage. Corriger davantage d'erreurs nécessiterait une mémoire plus importante qui rendrait difficile la réalisation du circuit intégré suivant la technologie actuelle sachant qu'outre cette mémoire, ce circuit comporte des dispositifs complexes et de texture non régulière, donc de surface élevée. Cependant, il est possible d'étendre le circuit à des codes RS pour lesquels M = 8, et cette limite de 15 erreurs est seulement liée à l'état de la technologie courante. La distance de Hamming de ces codes est comme indiquée ci-dessus choisie égale à 2t + 1 et peut être portée à 2t + 2 si j'utilisateur le désire pour minimiser le taux de faux décodages obtenus lorsque la capacité de correction a été dépassée et que le décodeur a été pris en défaut.

Ces codes sont utilisés en tant que détecteurs et correcteurs d'erreurs et d'effacements, ceci est usuel pour les codes Reed-Solomon mais pas pour les codes BCH pour lesquels il n'est pas prévu d'indication de validité. Pour ces derniers un mode de fonctionnement prévoit que chacun des bits d'un mot de code peut être répété plusieurs fois et qu'un vote majoritaire pondéré est alors effectué sur les répliques d'un bit donné avant le décodage proprement dit. Une majorité définie au préalable est nécessaire pour que le bit en question soit considéré comme valide. Sinon il est considéré comme effacé, mais sa position est connue. Un bit quelconque peut lui-même être effacé tout comme un symbole M-aire de m bits dans le cas des codes RS.

Dans un certain nombre d'applications il est nécessaire d'avoir un code pour transmettre des données et un deuxième code pour transmettre les signalisations. Le dispositif est programmable pour en tenir compte de la manière suivante : un premier code dit code de base de paramètres n et k est choisi. A partir de ce premier code on définit un deuxième code obtenu par raccourcissement du précédent, ce raccourcissement étant réalisé en positionnant implicitement un certain nombre de symboles de poids fort à 0, et, dans le cas des codes Reed-Solomon, en omettant éventuellement de transmettre un certain nombre de symboles de poids faible qui sont des symboles de redondance. Au décodage ces symboles non transmis seront considérés comme effacés. Par exemple, pour un code de base (n = 31, k = 15) qui correspond à 15 symboles d'information et 16 symboles de redondance, ces 16 symboles de redondance permettant de corriger huit erreurs sur 31 bits ou quatre erreurs et huit effacements etc..., une version raccourcie de ce code consiste à transmettre 16 bits, sous forme (n' = 16, k' = 4) c'est-à-dire quatre symboles qui sont les derniers symboles du mot d'information et douze symboles qui sont les douze premiers symboles de redondance, les onze premiers symboles de l'information et les quatre derniers symboles de redondance n'étant pas transmis. Ce code permet de corriger six erreurs sur 16 symboles. Dans le cas où ces symboles sont des mots de cinq bits, quatre symboles d'information forment 20 bits.

En ce qui concerne la capacité effective de correction d'un code donné, cette capacité peut comme indiqué ci-dessus être modulée à volonté par l'utilisateur qui indique au dispositif le nombre maximum d'erreurs qu'il admet de corriger. Ce nombre peut aller de 0 à t, t étant défini comme la capacité théorique du code, c'est-à-dire le nombre maximum d'erreurs algébriquement corrigeable pour lequel le code a été construit. Dans ces conditions la correction n'est effectuée que si la relation suivante est vérifiée : deux fois le nombre d'erreurs plus le nombre d'effacements doit être inférieur ou égal à 2 fois la capacité effective de correction.

En relation avec le mode de réalisation décrit ci-dessus du codeur-décodeur et les explications données ci-dessus en relation avec les codes, les modes de fonctionnement du codeur-décodeur sont définis de la manière suivante :

Le processeur a été conçu comme indiqué ci-dessus pour fonctionner en chargeant le moins possible le microprocesseur hôte. A la mise sous tension ou à tout autre instant, si l'on désire changer les codes, les caractéristiques des deux codes utilisés doivent être communiquées au codeur-décodeur intégré via l'interface. Ces caractéristiques sont la nature du code, BCH ou RS, sa longueur, sa capacité effective de correction. Des calculs d'initialisation sont commandés et le codeur-décodeur est alors disponible pour effectuer des codages ou des décodages sur l'ordre du microprocesseur.

Ainsi, si le microprocesseur commande une opération de décodage, le codeur-décodeur attend que l'extérieur lui ait fourni le nombre correspondant de symboles. Alors seulement le décodage est commencé, puis lorsqu'il est terminé le codeur-décodeur est en position d'attente jusqu'à ce que le mot décodé soit lu par le microprocesseur extérieur. Ensuite en l'absence d'ordre le codeur-décodeur est remis automatiquement en attente de symboles à décoder.

Le microprocesseur extérieur peut à tout moment interrompre le dispositif, il peut également en connaître l'état par le système décrit ci-dessus de lecture transparente du mot d'état, ou bien lui demander de transmettre une interruption IR lorsque le traitement demandé est terminé.

Comme indiqué ci-dessus également, les entrées et les sorties peuvent se faire en série avec un modulateur-démodulateur par exemple ou en parallèle avec le microprocesseur, les deux sens étant indépendants.

L'invention n'est pas limitée au mode de réalisation du codeur-décodeur précisémment décrit ci-dessus. En particulier, pour des codes construits sur un corps de Galois CG (256), les modifications à apporter sont liées au registre 478 stockant les identités possibles du corps de Galois, au multiplieur 470 qui doit comporter les éléments nécessaires : portes supplémentaires dans les ensembles 471, 472, largeur plus grande du bus 600 et des mots à traiter ou mémoriser et un circuit logique adapté aux produits dans ce corps de Galois.

## Revendications

1. Codeur-décodeur de codes de blocs, paramètrable, un bloc étant constitué avant codage de k symboles d'information et après codage de n symboles, n k, comportant :
   - une horloge (200),
   - un circuit d'interface (500) adapté à la réception de blocs de données à coder ou à décoder, et à la transmission de blocs codés ou décodés ;
   - un circuit de gestion (100) ;
   - un opérateur arithmétique (300) pour effectuer des opérations simples sur des nombres entiers signes ;
   - un opérateur Galois (400) pour effectuer des additions et des multiplications sur des éléments de corps de Galois CG(M = $2^m$), où M est le nombre d'éléments du corps et m la caractéristique de ce corps, n étant au plus égal à M-1, les blocs de k symboles d'information à coder et les blocs codés de n symboles ainsi que les blocs corrigés de n symboles et les blocs décodés de k symboles appartenant au même corps ; caractérisé en ce que :
   - le circuit de gestion (100) comporte un circuit séquenceur (140), une mémoire programme (110) et un registre microinstruction associé (120) dont la sortie est couplée à un bus d'instructions (125), et un circuit de décodage d'instructions et de multiplexage de tests (130), couplé au bus d'instructions (125) et à un bus interne de données (600),
   - l'opérateur arithmétique (300) comporte une unité arithmétique et logique (350), une mémoire vive (310) à double accès couplée à l'unité arithmétique et logique (350), l'entrée de la mémoire vive (310) étant reliée au bus d'instructions (125), ou au bus interne (600), ou à la sortie de l'unité arithmétique et logique (350) ou à une sortie de la mémoire (310) elle-même, via un circuit de commutation (320) commandée par un mot de commande de configuration (CONF.AR) issu du circuit de gestion (100) et programmé dans la mémoire programmable (110),
   - l'opérateur Galois (400) comporte une mémoire vive (410) à double accès, un multiplieur dans les corps de Galois (470), un additionneur dans les corps de Galois (480) et un accumulateur (481), l'entrée de la mémoire étant reliée au bus d'instructions (125), ou au bus interne (600), ou à la sortie de l'accumulateur (481), ou à la sortie de l'additionneur (480) ou à la sortie du multiplieur (470) via un circuit de commutation (420, 484) commandé par un mot de commande de configuration (CONF.GA) issu du circuit de gestion (100) et programmé dans la mémoire programme (110), la caractéristique du corps Galois à utiliser étant commandée via le circuit d'interface.

2. Codeur-décodeur selon la revendication 1, caractérisé en ce que l'ensemble des circuits constitutifs est intégré sur un substrat unique.

3. Codeur-décodeur selon l'une des revendications 1 et 2, caractérisé en ce que les entrées d'adressage de la mémoire vive (410) de l'opérateur Galois sont reliées au bus d'instructions ou respectivement à la sortie d'un compteur-décompteur d'adresses (450) ou d'un décompteur (460) via des circuits de commutation (430, 440) également commandés par le circuit de gestion, ces décompteurs permettant d'effectuer des séries d'opérations identiques sur des éléments rangés dans la mémoire vive (410) à des adresses successives en une seule instruction issue de la mémoire programme (110).

4. Codeur-décodeur selon la revendication 3, caractérisé en ce que :
   - une entrée du multiplieur (470) est reliée à une première sortie de la mémoire vive (410) l'autre entrée de ce multiplieur étant reliée soit à la seconde sortie de la mémoire vive (410) soit à la sortie de l'accumulateur (481) via un circuit de commutation (482) également commandé par le circuit de gestion (100),
   - une entrée de l'additionneur (480) est reliée à la sortie du multiplieur (470), l'autre entrée de l'additionneur étant reliée soit à la sortie de l'accumulateur (481) soit à la seconde sortie de la mémoire vive, via un circuit de commutation (483) commandé par le circuit de gestion, l'opérateur Galois permettant d'effectuer des séries de multiplications et d'additions itératives en une seule instruction, une multiplication, une addition et un transfert dans l'accumulateur pouvant être réalisés en un seul pas d'horloge.

5. Codeur-décodeur selon l'une quelconque des revendications 1 à 4, caractérisé en ce que le multiplieur dans les corps de Galois (470) comporte un ensemble de portes ET (471), comportant $m^2_{max}$ portes ET, $m_{max}$ étant la caractéristique du corps de Galois de degré maximal susceptible d'être utilisé, pour former tous les produits possibles entre les symboles $a_i$ et $b_j$ définissant les deux éléments du corps de Galois à multiplier quand i et j varient de 0 à m-1, un ensemble de portes OU exclusif (472) pour former les au plus 2m-1 sommes de produits $a_i b_j$ de même degré q = i + j, et des circuits logiques (473, 474, 475, 476), chacun associé à un corps de Galois prédéterminé, pour former l'élément du corps résultant du produit des deux éléments d'entrée, les sorties de ces circuits logiques étant reliées à la sortie du multiplieur via un multiplexeur (477) commandé par la caractéristique m du corps utilisé.

6. Codeur-décodeur selon l'une des revendications 1 à 5, caractérisé en ce que l'opérateur arithmétique (300) comporte en outre un registre accumulateur (380) dont l'entrée est reliée à la sortie du circuit de commutation (320) et dont le chargement est commandé par le circuit de gestion en fonction de l'instruction, les entrées d'adressage de la mémoire vive (310) étant reliées au bus d'instructions (125) ou à la sortie du registre (380) via des circuits de commutation d'adressage (330, 340), les entrées de l'unité arithmétique et logique (350) étant respectivement reliées aux sorties de la mémoire vive (310) ou à la sortie du registre (380) ou au bus d'instructions (125) respectivement via des circuits de commutation (360, 370), les circuits de commutation (330, 340, 360, 370) étant également commandés par le mot de configuration arithmétique.

7. Codeur-décodeur selon l'une des revendications 1 à 6, caractérisé en ce que le circuit d'interface (500) comporte une entrée ($D_{IN}$) adaptée à la réception de données en série et une entrée d'horloge externe (CK) associée, une entrée (700) adaptée à la réception de données en parallèle, et l'horloge externe (E) associée, une sortie pour des données série ($D_{OUT}$) et une sortie pour des données parallèles (700), les types de données entrantes et sortantes étant programmables indépendemment.

8. Codeur-décodeur selon la revendication 7, caractérisé en ce que le circuit d'interface comporte en outre un générateur d'interruption (593) pour délivrer un signal d'interruption (IR) à l'extérieur du codeur-décodeur indiquant l'état d'avancement d'une opération demandée par l'extérieur.

**Claims**

1. A parametrable encoder and decoder for block codes, one block being constituted prior to encoding by k symbols of information and after encoding by n symbols, n k, comprising:
- a clock (200),
- an interface circuit (500) adapted for the reception of data blocks to be encoded or to be decoded and for the transmission of encoded or decoded blocks,
- a controlling circuit (100);
- an arithmetic operator (300) in order to effect simple operations on signed whole numbers;
- a Galois operator (400) for performing additions and multiplications of the elements of the Galois body $CG(M = 2^m)$, wherein M is the number of elements of the body and m is the characteristic of the body, n being at the most equal to M-1, the blocks of k symbols of information to be encoded and the encoded blocks of n symbols as well as the corrected blocks of n symbols and the decoded blocks of k symbols belonging to the same block;

characterized in that:
- the controlling circuit (100) comprises a sequencing circuit (140), a program memory (110) and an associated microinstruction register (120) whose output is coupled with an instruction bus (125), and an instruction circuit (130) for decoding and for test multiplexing, coupled with the instruction bus (125) and with an internal data bus (600),
- the arithmetic operator (300) comprises an arithmetic and logic unit (350), a double access RAM (310) coupled with the arithmetic and logic unit (350), the input of the RAM (310) being connected with the instruction bus (125), or with the internal bus (600), or with the output of the arithmetic and logic unit (350), or with an output of the memory (310) itself, via a switching circuit (320) controlled by a configuration control word (CONF.AR) issued by the controlling circuit (100) and stored in the programmable memory (110),
- the Galois (400) operator comprises a double access RAM (410), a multiplier in the Galois body (470), an adder in the Galois body (480) and an accumulator (481), the input of the memory being connected with the instruction bus (125), or with the internal bus (600), or with the output of the accumulator (481), or with the output of the adder (480) or with the output of the multiplier (470) via a switching circuit (420 and 484) controlled by a configuration control word (CONF.GA) issued by the controlling circuit (100) and stored in the program memory (110), the characteristic of the Galois body to be utilized being controlled via the interface circuit.

2. The encoder and decoder as claimed in claim 1, characterized in that the entirety of the circuits constituting same is integrated on a single substrate.

3. The encoder and decoder as claimed in claim 1 or claim 2, characterized in that the addressing inputs of the RAM (410) of the Galois operator are connected with the instruction bus or respectively with the output of an up and down address counter (450) or a down counter (460) via switching circuits (430 and 440) also controlled by the controlling circuit, said down counters making possible the performance of series of identical operations on the elements assembled in the RAM (410) at successive addresses in a single instruction issued by the program memory (110).

4. The encoder and decoder as claimed in claim 3, characterized in that:
- one input of the multiplier (470) is connected with a first output of the RAM (410), the other input of this multiplier being connected either with the second output of the RAM (410) or with the output of the accumulator (481) via a switching circuit (482) also controlled by the controlling circuit (100),
- one input of the adder (480) is connected with the output of the multiplier (470), the other input of the adder being connected either with the output of the accumulator (481), or with the output of the RAM, via a switching circuit (483) controlled by the controlling circuit, the Galois operator making possible the performance of series of iterative multiplications and additions in a single instruction, a multiplication, an addition and a transfer in the accumulator being able to be effected in a single clock beat.

5. The encoder and decoder as claimed in any one of the preceding claims 1 through 4, characterized in that the multiplier in the Galois body (470) comprises a set of AND gates (471) comprising $m^2_{max}$ AND gates, $m_{max}$ being the characteristic of the Galois body of the maximum degree able to be utilized, in order to form all the possible products between the symbols $a_i$ and $b_j$ defining the two elements of the Galois body to be multiplied when i and j vary from 0 to m-1, a set of exclusive OR gates (472) in order to form at the most 2m-1 sums of the products $a_i$, $b_j$ of the same degree $q = i + j$, and logic circuits (473, 474, 475 and 476) each associated with a predetermined Galois body, in order to form the element of the body resulting from the product of the two input elements, the outputs of these logic circuits being connected with the output of the multiplier via a multiplexer (477) controlled by the characteristic m of the body utilized.

6. The encoder and decoder as claimed in any one of the claims 1 through 5, characterized in that the arithmetic operator (300) comprises furthermore an accumulator register (380) whose input is connected with the output of the switching circuit (320) and the loading of which is controlled by the controlling circuit as a function of the instruction, the addressing inputs of the RAM (310) being connected with the instruction bus (125) or with the output of the register (380) via address switching circuits (330 and 340), the inputs of the arithmetic and logic unit (350) being respectively connected with the outputs of the RAM (310) or with the output of the register (380) or with the instruction bus (125) respectively via switching circuits (360 and 370), the switching circuits (330, 340, 360 and 370) being also controlled by the arithmetic configuration word.

7. The encoder and decoder as claimed in any one of the claims 1 through 6, characterized in that the interface circuit (500) comprises an output ($D_{IN}$) adapted for the reception of serial data and an associated external clock input (CK), a input (700) adapted for the reception of parallel data, and the external associated clock (E), an output for the serial data ($D_{OUT}$) and an output for parallel data (700), the types of input and output data being programmable independently.

8. The encoder and decoder as claimed in claim 7, characterized in that the interface circuit furthermore comprises an interrupt generator (593) in order to deliver an interrupt signal (IR) to the exterior of the encoder and decoder indicating the progress of an operation requested by the exterior.

## Patentansprüche

1. Parametrierbarer Kodierer-Dekodierer für Blockkodes, wobei ein Block vor der Kodierung k Informationszeichen und nach der Kodierung n Zeichen n > k aufweist, mit:
   - einem Taktgeber (200),
   - einer Schnittstellenschaltung (500), die für den Empfang von zu kodierenden oder zu dekodierenden Datenblöcken und für die Übertragung der kodierten oder dekodierten Blöcke ausgebildet ist;
   - einer Steuerschaltung (100);
   - einem arithmetischen Rechenwerk (300) zum Ausführen von einfachen Operationen an vorzeichenbehafteten ganzen Zahlen; und
   - einem Galois-Rechenwerk (400) zum Ausführen von Additionen und Multiplikationen an den Elementen des Galois-Körpers CG (M = 2m), wobei M die Anzahl der Elemente des Körpers und m die charakteristische Zahl dieses Körpers sind, wobei n höchstens gleich M-1 ist, wobei die Blöcke von k Zeichen der zu kodierenden Information und die kodierten Blöcke von n Zeichen sowie die korrigierten Blöcke von n Zeichen und die dekodierten Blöcke von k Zeichen demselben Körper zugehören;

   dadurch gekennzeichnet, daß:

   - die Steuerschaltung (100) versehen ist mit einer Folgerschaltung (140), einem programmierbaren Speicher (110) und einem zugehörigen Mikrobefehl-Register (120), dessen Ausgang mit einem Befehlsbus (125) verbunden ist, und einer mit dem Befehlsbus (125) und mit einem internen Datenbus (600) verbundenen Schaltung für die Befehlsdekodierung und die Test-Multiplexierung (130),
   - das arithmetische Rechenwerk (300) versehen ist mit einer Arithmetik- und Logikeinheit (350) und einem Arbeitsspeicher (310) mit Zweifachzugriff, der mit der Arithmetik- und Logikeinheit (350) verbunden ist, wobei der Eingang des Arbeitsspeichers (310) über eine durch ein von der Steuerschaltung (100) ausgegebenes und im programmierbaren Speicher (110) programmiertes Konfigurations-Steuerwort (CONF.AR) gesteuerte Wechselschaltung (320) mit dem Befehlsbus (125) oder mit dem internen Bus (600) oder mit dem Ausgang der Arithmetik- und Logikeinheit (350) oder mit einem Ausgang des Speichers (310) selbst verbunden ist, und
   - das Galois-Rechenwerk (400) versehen ist mit einem Arbeitsspeicher (410) mit Zweifachzugriff, einem Multiplizierer in den Galois-Körpern (470), einem Addierer in den Galois-Körpern (480) und einem Akkumulator (481), wobei der Eingang des Speichers über eine durch ein von der Steuerschaltung (100) ausgegebenes und im programmierbaren Speicher (110) programmiertes Konfigurations-Steuerwort (CONF.GA) gesteuerte Wechselschaltung (420, 484) mit dem Befehlsbus (125) oder mit dem internen Bus (600) oder mit dem Ausgang des Akkumulators (481) oder mit dem Ausgang des Addierers (480) oder mit dem Ausgang des Multiplizierers (470) verbunden ist, wobei die charakteristische Zahl des zu verwendenden Galois-Körpers über die Schnittstellenschaltung gesteuert wird.

2. Kodierer-Dekodierer gemäß Anspruch 1, dadurch gekennzeichnet, daß die Gesamtheit der konstitutiven Schaltungen auf einem einzigen Substrat integriert ist.

3. Kodierer-Dekodierer gemäß einem der Ansprüche 1 und 2, dadurch gekennzeichnet, daß die Adressen-Eingänge des Arbeitsspeichers (410) des Galois-Rechenwerks über ebenfalls von der Steuerschaltung gesteuerte Wechselschaltungen (430, 440) mit dem Befehlsbus oder mit dem Ausgang eines Adressen-Aufwärts-/Abwärtszählers (450) oder mit dem Ausgang eines Abwärtszählers (460) verbunden sind, wobei diese Abwärtszähler mittels eines einzigen vom programmierbaren Speicher (110) ausgegebenen Befehls die Ausführung von Reihen von identischen Operationen an im Arbeitsspeicher (410) an aufeinanderfolgenden Adressen angeordneten Elementen erlauben.

4. Kodierer-Dekodierer gemäß Anspruch 3, dadurch gekennzeichnet, daß:
   - ein Eingang des Multiplizierers (470) mit einem ersten Ausgang des Arbeitsspeichers (410) verbunden ist, wobei der andere Eingang dieses Multiplizierers über eine ebenfalls von der Steuerschaltung (100) gesteuerte Wechselschaltung (482) entweder mit dem zweiten Ausgang des Arbeitsspeichers (410) oder mit dem Ausgang des Akkumulators (481) verbunden ist,
   - ein Eingang des Addierers (480) mit dem Ausgang des Multiplizierers (470) verbunden ist, wobei der andere Eingang des Addierers über eine von der Steuerschaltung gesteuerte Wechselschaltung (483) entweder mit dem Ausgang des Akkumulators (481) oder mit dem zweiten Ausgang des Arbeitsspeichers verbunden ist, wobei das Galois-Rechenwerk die Ausführung von Reihen von iterativen Multiplikationen und Additionen mittels eines einzigen Befehls erlaubt, wobei eine Multiplikation, eine Addition und eine Verschiebung im Akkumulator während eines einzigen Taktschrittes ausgeführt werden können.

5. Kodierer-Dekodierer gemäß einem der Ansprüche 1 bis 4, dadurch gekennzeichnet, daß der Multiplizierer in den Galois-Körpern (470) versehen ist mit einer Gruppe von UND- Gattern (471), die m2max UND-Gatter aufweist, wobei mmax die charakteristische Zahl des Galois-Körpers von maximal verwendbarem Grad ist, um sämtliche möglichen Produkte zwischen den die zwei miteinander zu multiplizierenden Elemente des Galois-Körpers definierenden Zeichen ai und bj zu bilden, wobei i und j zwischen 0 und m-1 variieren, einer Gruppe von Exklusiv- ODER-Gattern (472), um die mindestens 2m-1 Summen der Produkte ai bj gleichen Grades $q = i + j$ zu bilden, und Logikschaltungen (473, 474, 475, 476), von denen jede einem vorgegebenen Galois-Körper zugeordnet ist, um das Element des Körpers zu bilden, das sich aus dem Produkt der zwei Eingangselemente ergibt, wobei die Ausgänge dieser Logikschaltungen über einen durch die charakteristische Zahl m des verwendeten Körpers gesteuerten Multiplexer (477) mit dem Ausgang des Multiplizierers verbunden sind.

6. Kodierer-Dekodierer gemäß einem der Ansprüche 1 bis 5, dadurch gekennzeichnet, daß das arithmetische Rechenwerk (300) außerdem ein Akkumulator-Register (380) aufweist, dessen Eingang mit dem Ausgang der Wechselschaltung (320) verbunden ist und dessen Laden von der Steuerschaltung in Abhängigkeit vom Befehl gesteuert wird, wobei die Adresseneingänge des Arbeitsspeichers (310) über Adressenwechselschaltungen (330, 340) mit dem Befehlsbus (125) oder mit dem Ausgang des Registers (380) verbunden sind, wobei die Eingänge der Arithmetik- und Logikeinheit (350) über Wechselschaltungen (360, 370) jeweils mit den Ausgängen des Arbeitsspeichers (310) oder mit dem Ausgang des Registers (380) oder mit dem Befehlsbus (125) verbunden sind, wobei die Wechselschaltungen (330, 340, 360, 370) ebenfalls vom Rechenkonfigurationswort gesteuert werden.

7. Kodierer-Dekodierer gemäß einem der Ansprüche 1 bis 6, dadurch gekennzeichnet, daß die Schnittstellenschaltung (500) versehen ist mit einem Eingang (DIN), der für den seriellen Empfang von Daten ausgebildet ist, und einem Eingang für einen zugeordneten externen Takt (CK), einem Eingang (700), der für den parallelen Empfang von Daten und eines zugeordneten externen Taktes (E) ausgebildet ist, einem Ausgang für die seriellen Daten (DOUT) und einem Ausgang für die parallelen Daten (700), wobei die Typen von eingegebenen und ausgegebenen Daten unabhängig voneinander programmierbar sind.

8. Kodierer-Dekodierer gemäß Anspruch 7, dadurch gekennzeichnet, daß die Schnittstellenschaltung außerdem einen Unterbrechungsgenerator (493) aufweist, um aus dem Kodierer-Dekodierer ein Unterbrechungssignal (IR) auszugeben, das den Zustand des Fortgangs einer von außen angeforderten Operation angibt.

Fig.1

## Fig.2

Fig.3

BUS INTERNE 600

BUS INSTRUCTION 125

320

310

WRAM_AR

ENTRÉE

MÉMOIRE
RAM

H

ADA

ADB

330

SORTIE
A

SORTIE
B

0    1

WREG_AR

340

1    0

380

REGISTRE

360

370

H

350

CONF_AR

E1

E2

UNITÉ
ARITHMÉTIQUE
ET LOGIQUE

Fig.4

390

SB2

TPAIR  TNÉGATIF  TNUL

Fig.5

Fig.6

Fig.7